# EUROPEAN PATENT APPLICATION

(11) **EP 4 739 047 A1**
(43) Date of publication of application: **06.05.2026**
(21) Application number: 25212611.5
(22) Date of filing: 31.10.2025
(51) Int. Cl.: H10H 29/49

(54) **DISPLAY PANEL AND DISPLAY APPARATUS**

(30) Priority: 01.11.2024 CN 202411553971
(71) Applicant: Tianma Advanced Display Technology Institute (Xiamen) Co., Ltd., 361101 Xiamen (CN)
(72) Inventor: JIA, Zhenyu, Xiamen, 361101 (CN); YANG, Bo, Xiamen, 361101 (CN); MENG, Fanqing, Xiamen, 361101 (CN); XI, Kerui, Xiamen, 361101 (CN); WU, Tianyi, Xiamen, 361101 (CN); ZHAI, Yingteng, Xiamen, 361101 (CN); ZHANG, Liwei, Xiamen, 361101 (CN); LI, Wenliang, Xiamen, 361101 (CN); HUANG, Jiali, Xiamen, 361101 (CN)
(74) Representative: Boult Wade Tennant LLP

(57) **Abstract**

Provided are a display panel (100) and a display apparatus (1000). The display panel (100) comprises a substrate (00) and a first metal layer (M1) located on one side of the substrate (00), the first metal layer (M1) comprises a first metal portion (M11) and a second metal portion (M12) which are connected to each other, the first metal portion (M11) comprises a plurality of first exhaust holes (10), the second metal portion (M12) comprises a plurality of second exhaust holes (20), and an arrangement mode of the plurality of first exhaust holes (10) is different from an arrangement mode of the plurality of second exhaust holes (20). In the display panel (100) and the display apparatus (1000), a voltage drop of a signal transmitted by the first metal layer (M1) can be reduced, the display uniformity can be improved, the risk that film layer delamination of a large area metal can be reduced, and the product performance reliability can be improved.

## Description

### TECHNICAL FIELD

The present disclosure relates to the field of display technology, and in particular, to a display panel and a display apparatus.

### BACKGROUND

A light-emitting diode (LED) is a common light-emitting device and is widely used in fields such as lighting and display. With the development of display technology, a display product using Mini LEDs and Micro LEDs as display pixels has emerged. In the display product, a voltage drop on a power supply structure that drives the pixels to emit light affects the display uniformity. However, if the area of the power supply structure is increased to reduce the voltage drop, there will be a problem that a large area metal is prone to film layer delamination, which affects the performance reliability of the product.

### SUMMARY

Embodiments of the present disclosure provide a display panel and a display apparatus to improve the performance reliability of the product.

In a first aspect, an embodiment of the present disclosure provides a display panel including a substrate and a first metal layer located on one side of the substrate, where the first metal layer comprises a first metal portion and a second metal portion which are connected to each other; and
the first metal portion comprises a plurality of first exhaust holes, and the second metal portion comprises a plurality of second exhaust holes, where an arrangement mode of the plurality of first exhaust holes is different from an arrangement mode of the plurality of second exhaust holes.

In a second aspect, based on the same inventive concept, an embodiment of the present disclosure further provides a display apparatus including the display panel provided by the above embodiment of the present disclosure.

Other embodiments in the summary are as disclosed in the claims as appended.

The display panel and the display apparatus provided by the embodiments of the present disclosure have the following beneficial effects: in the embodiments of the present disclosure, the differentiated design of the arrangement modes of the exhaust holes is performed in coordination with the positions of different metal portions in the first metal layer, which can facilitate gas discharge during the fabrication process, preventing film layer delamination of the first metal layer. In application, by designing the first metal layer as a large area metal layer, a voltage drop of a signal transmitted by the first metal layer can be reduced, the display uniformity can be enhanced, the risk of film layer delamination of the large area metal can also be reduced, and the performance reliability of the product can be improved.

### BRIEF DESCRIPTION OF DRAWINGS

To more clearly illustrate the technical solutions in the embodiments of the present disclosure or in the prior art, the drawings required to be used in the description of the embodiments or the prior art are briefly introduced below. Apparently, the drawings in the following description are some of the embodiments of the present invention. For those skilled in the art, other drawings can also be obtained based on these drawings without any creative efforts.
FIG. 1 is a partial schematic diagram of a display panel provided by an embodiment of the present disclosure;
FIG. 2 is a schematic diagram of another display panel provided by an embodiment of the present disclosure;
FIG. 3A is a partial schematic diagram of another display panel provided by an embodiment of the present disclosure;
FIG. 3B is a partial schematic diagram of another display panel provided by an embodiment of the present disclosure;
FIG. 4 is a partial schematic diagram of another display panel provided by an embodiment of the present disclosure;
FIG. 5 is a partial schematic diagram of another display panel provided by an embodiment of the present disclosure;
FIG. 6 is a schematic diagram of another display panel provided by an embodiment of the present disclosure;
FIG. 7A is a schematic diagram of another display panel provided by an embodiment of the present disclosure;
FIG. 7B is a schematic diagram of a film layer structure of another display panel provided by an embodiment of the present disclosure;
FIG. 8 is a schematic diagram of another display panel provided by an embodiment of the present disclosure;
FIG. 9A is a schematic diagram of another display panel provided by an embodiment of the present disclosure;
FIG. 9B is a schematic diagram of another display panel provided by an embodiment of the present disclosure;
FIG. 9C is a schematic diagram of a pixel circuit provided by an embodiment of the present disclosure;
FIG. 10 is a schematic diagram of another display panel provided by an embodiment of the present disclosure;
FIG. 11 is a schematic diagram of another display panel provided by an embodiment of the present disclosure;
FIG. 12 is a layout design diagram of a first metal layer of another display panel provided by an embodiment of the present disclosure;
FIG. 13 is a partial schematic diagram of another display panel provided by an embodiment of the present disclosure;
FIG. 14A is a schematic diagram of another display panel provided by an embodiment of the present disclosure;
FIG. 14B is an enlarged view of a region Q1 in FIG. 14A;
FIG. 15 is a partial enlarged view of a region Q2 in FIG. 10;
FIG. 16 is a schematic diagram of a display apparatus provided by an embodiment of the present disclosure; and
FIG. 17 is a schematic diagram of another display apparatus provided by an embodiment of the present disclosure.

### DESCRIPTION OF EMBODIMENTS

To make the objectives, technical solutions, and advantages of the embodiments of the present disclosure clearer, the technical solutions in the embodiments of the present disclosure will be described clearly and completely below in conjunction with the accompanying drawings in the embodiments of the present disclosure. Apparently, the described embodiments are some, rather than all, of the embodiments of the present disclosure. All other embodiments obtained by a person of ordinary skill in the art based on the embodiments of the present disclosure without creative efforts shall fall within the protection scope of the present disclosure.

The terms used in the embodiments of the present disclosure are merely for the purpose of describing specific embodiments and are not intended to limit the present disclosure. The singular forms "a," "said," and "the" used in the embodiments of the present disclosure and the appended claims are also intended to include the plural forms, unless the context clearly indicates otherwise.

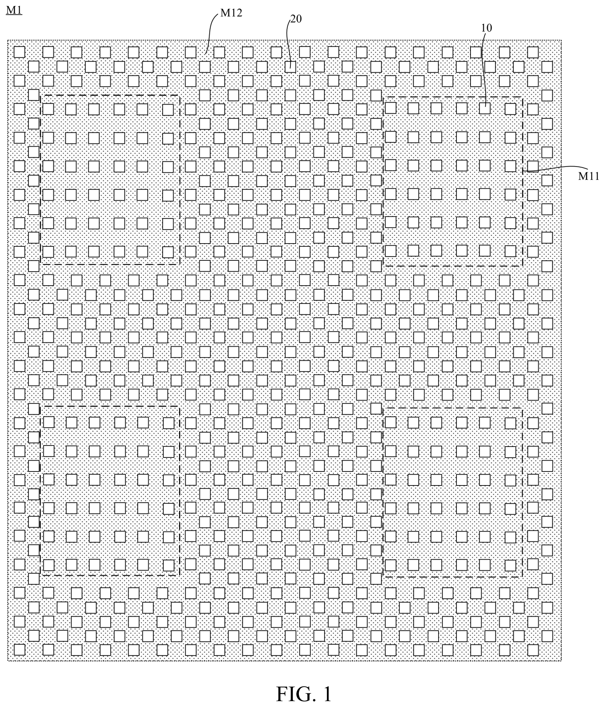

FIG. 1 is a partial schematic diagram of a display panel provided by an embodiment of the present disclosure, and FIG. 1 illustrates a partial position of a first metal layer on a substrate. As shown in FIG. 1, the first metal layer M1 includes a first metal portion M11 and a second metal portion M12 which are connected to each other. The first metal portion M11 includes a plurality of first exhaust holes 10, and the second metal portion M12 includes a plurality of second exhaust holes 20. The exhaust holes penetrate the metal layer in a thickness direction of the metal layer, and the exhaust holes are equivalent to through-holes in the metal layer. The gas exhaust holes are used as gas exhaust channels during the fabrication process, which can prevent the first metal layer M1 with a large area from film layer delamination due to the inability to exhaust gas. An arrangement mode of the plurality of first exhaust holes 10 is different from an arrangement mode of the plurality of second exhaust holes 20. The arrangement mode of the exhaust holes includes parameters such as an arrangement rule of the exhaust holes in a row direction/a column direction, a pitch between the exhaust holes in the row direction/the column direction, a size of the exhaust holes in the row direction/the column direction, a spacing between two adjacent exhaust holes in the row direction/the column direction, and an arrangement density of the exhaust holes, etc.

In the embodiment of the present disclosure, the second metal portion M12 is connected to the first metal portion M11, and the second metal portion M12 at least partially surrounds the first metal portion M11. The connection between the first metal portion M11 and the second metal portion M12 forms the first metal layer M1 as a large area metal layer in the display panel. The first metal portion M11 and the second metal portion M12, which are located at different positions in the first metal layer M1, are provided to respectively include a plurality of exhaust holes, with the arrangement modes of the exhaust holes in the two metal portions being different. In some implementations, the first metal layer M1 can be used to transmit a power supply voltage required for display. Providing the first metal layer M1 as a large area layer can reduce the voltage drop of the power supply voltage and improve display uniformity.

In the embodiment of the present disclosure, the differentiated design of the arrangement modes of the exhaust holes is performed in coordination with the positions of different metal portions in the first metal layer M1, which can facilitate gas discharge during the fabrication process, preventing film layer delamination of the first metal layer M1. In application, by designing the first metal layer M1 as a large area metal layer, a voltage drop of a signal transmitted by the first metal layer M1 can be reduced, the display uniformity can be enhanced, the risk of film layer delamination of the large area metal can also be reduced, and the performance reliability of the product can be improved.

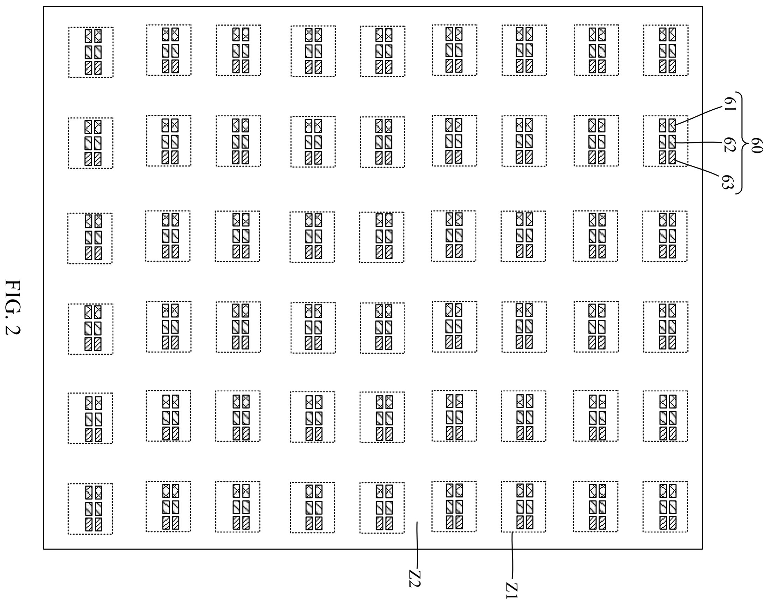

In some implementations, FIG. 2 is a schematic diagram of another display panel provided by an embodiment of the present disclosure. As shown in FIG. 2, the display panel includes a pixel region Z1 and a non-pixel region Z2. The pixel region Z1 includes light-emitting elements 60. The light-emitting elements 60 are Mini LEDs or Micro LEDs. Optionally, one pixel region Z1 includes at least one red light-emitting element 61, at least one green light-emitting element 62, and at least one blue light-emitting element 63. In FIG. 2, the arrangement mode of the light-emitting elements 60 in the pixel region Z1 is merely illustrative and does not limit the present disclosure. At least a part of the first metal portion M11 is located in the pixel region Z1, and the second metal portion M12 is located in the non-pixel region Z2. To drive the light-emitting elements 60 to emit light, a positive electrode and a negative electrode of the light-emitting element 60 need to be connected to respective structures. For example, the positive electrode is connected to a positive power supply structure through a pixel circuit, and the negative electrode is connected to a negative power supply structure. Therefore, respective metal connection electrodes need to be provided for the positive and negative poles at the positions where the light-emitting elements 60 are located. When the first metal layer M1 adopts the design of a large area metal, the differentiated design of the arrangement modes of the exhaust holes in the first metal layer M1 is performed in cooperation with the positions of the pixel region Z1 and the non-pixel region Z2, which can facilitate gas discharge during the fabrication process, preventing the occurrence of film layer delamination, thereby preventing the product performance reliability from being affected.

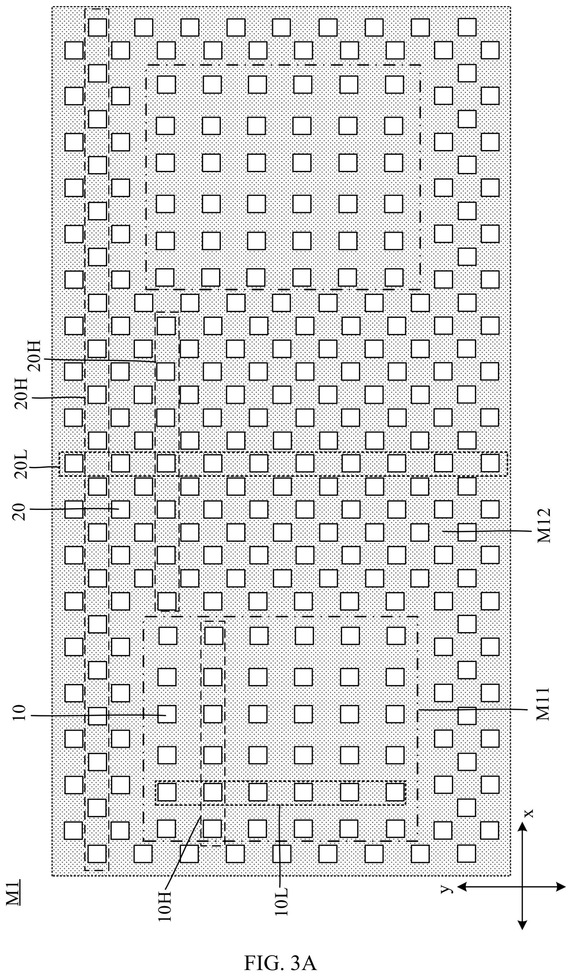

In some implementations, FIG. 3A is a partial schematic diagram of another display panel provided by an embodiment of the present disclosure, and FIG. 3A illustrates the structures of the first metal portion M11 and the second metal portion M12 at a local position within the first metal layer M1. As shown in FIG. 3A, in the first metal portion M11, multiple first exhaust holes of the plurality of first exhaust holes 10 are arranged along a first direction y, multiple first exhaust holes of the plurality of first exhaust holes 10 are arranged along a second direction x, and the first direction y and the second direction x intersect with each other. For example, the first direction y is the column direction, and the second direction x is the row direction. In the second metal portion M12, multiple second exhaust holes of the plurality of second exhaust holes 20 are arranged along the first direction y, and multiple second exhaust holes of the plurality of second exhaust holes 20 are arranged along the second direction x. Multiple first exhaust holes of the plurality of first exhaust holes 10 being arranged along the first direction y means that the multiple first exhaust holes 10 arranged along the first direction y are located on substantially the same straight line extending along the first direction y. That is, the first exhaust holes 10 arranged along the same direction are substantially aligned and approximately not staggered in their arrangement direction. Similarly, multiple first exhaust holes of the plurality of first exhaust holes 10 arranged along the second direction x are substantially aligned and not staggered in their arrangement direction. Similarly, the arrangement of the second exhaust holes 20 along the first direction y/the second direction x can be understood with reference to this. Two adjacent first exhaust holes 10 in the first direction y mean that these two first exhaust holes 10 are adjacent to each other and are located on substantially the same straight line extending in the first direction y. Two adjacent first exhaust holes 10 in the second direction x mean that these two first exhaust holes 10 are adjacent to each other and are located on substantially the same straight line extending in the second direction x. Two second exhaust holes 20 adjacent in the first direction y/the second direction x can be understood with reference to this.

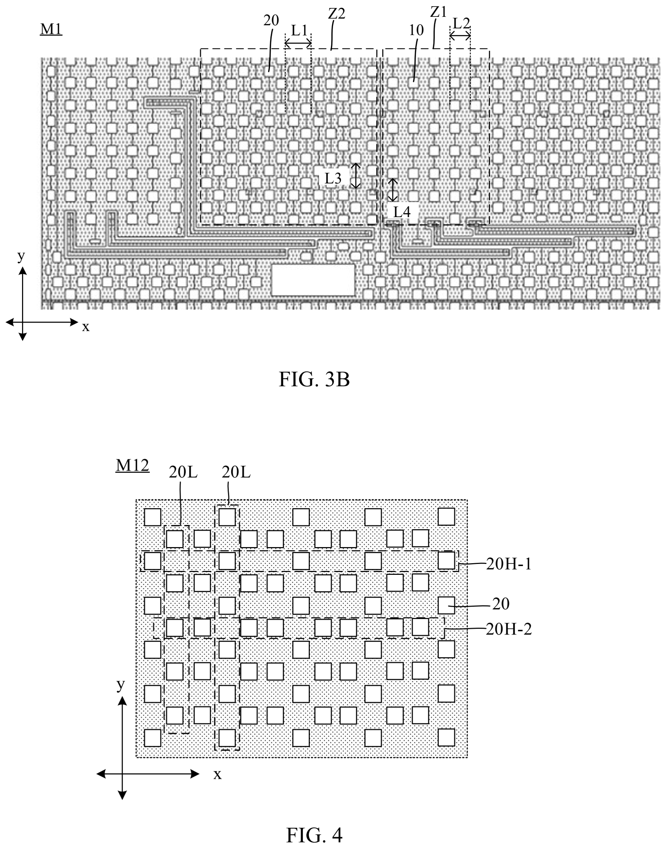

In some implementations, in the first direction y, a pitch between two adjacent first exhaust holes 10 is different from a pitch between two adjacent second exhaust holes 20; and/or in the second direction x, a pitch between two adjacent first exhaust holes 10 is different from a pitch between two adjacent second exhaust holes 20. The pitch between two adjacent exhaust holes in a certain direction refers to a spacing distance between the same positions on the two exhaust holes, such as the spacing distance between the centers of the two exhaust holes. FIG. 3B is a partial schematic diagram of another display panel provided by an embodiment of the present disclosure, and FIG. 3B illustrates a pixel region Z1 and a non-pixel region Z2. As shown in FIG. 3B, in the first direction y, a pitch between two adjacent first exhaust holes 10 is L4, and a pitch between two adjacent second exhaust holes 20 is L3, where L4≠L3. Optionally, L4<L3. In the second direction x, a pitch between two adjacent first exhaust holes 10 is L2, and a pitch between two adjacent second exhaust holes 20 is L1, where L1≠L2. Optionally, L2<L1. In the embodiment of the present disclosure, the pitch between adjacent first exhaust holes 10 and the pitch between adjacent second exhaust holes 20 in the first direction y and/or the second direction x are differentially set, and the pitches between the exhaust holes at different positions are adjusted, so that the arrangement mode of the plurality of first exhaust holes 10 and the arrangement mode of the plurality of second exhaust holes 20 are different, and the reasonable setting of the exhaust holes at different positions in the first metal layer can cooperate with structures in other film layers to meet the design requirements of the display panel. In the embodiment of the present disclosure, the shape of the first exhaust hole 10 and the shape of the second exhaust hole 20 are not limited, and they may be the same or different. In the drawings of the embodiment of the present disclosure, the shape of the first exhaust hole 10 and the shape of the second exhaust hole 20 are merely illustrated as rectangles for illustration.

In some implementations, in the first direction y, a width of the first exhaust hole 10 is equal to a width of the second exhaust hole 20, and a spacing between two adjacent first exhaust holes 10 is different from a spacing between two adjacent second exhaust holes 20. For example, the spacing between two adjacent first exhaust holes 10 in the first direction y is set to be greater than the spacing between two adjacent second exhaust holes 20 in the first direction y. As such, the pitch between the first exhaust holes 10 and the pitch between the second exhaust holes 20 in the first direction y can be made different, and in turn the arrangement mode of the plurality of first exhaust holes 10 is made different from the arrangement mode of the plurality of second exhaust holes 20.

In further implementations, in the second direction x, a width of the first exhaust hole 10 is equal to a width of the second exhaust hole 20, and a spacing between two adjacent first exhaust holes 10 is different from a spacing between two adjacent second exhaust holes 20. For example, the spacing between two adjacent first exhaust holes 10 in the second direction x is greater than the spacing between two adjacent second exhaust holes 20 in the second direction x. As such, the pitch between the first exhaust holes 10 and the pitch between the second exhaust holes 20 in the second direction x can be made different, and in turn the arrangement mode of the plurality of first exhaust holes 10 is made different from the arrangement mode of the plurality of second exhaust holes 20.

In some implementations, a hole area of the first exhaust hole 10 and a hole area of the second exhaust hole 20 are the same. The hole area of an exhaust hole refers to an area of an orthographic projection of the exhaust hole on a plane of the substrate. For example, the widths of the two types of exhaust holes in the first direction y are equal, and the widths of the two types of exhaust holes in the second direction x are equal. In the first direction y, the spacing between two adjacent first exhaust holes 10 is different from the spacing between two adjacent second exhaust holes 20; and/or in the second direction x, the spacing between two adjacent first exhaust holes 10 is different from the spacing between two adjacent second exhaust holes 20.

In some implementations, a hole area of the first exhaust hole 10 and a hole area of the second exhaust hole 20 are not the same. For example, the widths of the two types of exhaust holes in the first direction y are not equal, or the widths of the two types of exhaust holes in the second direction x are not equal. At the same time, it is provided that, in the first direction y, the spacing between two adjacent first exhaust holes 10 is equal to the spacing between two adjacent second exhaust holes 20; and/or in the second direction x, the spacing between two adjacent first exhaust holes 10 is equal to the spacing between two adjacent second exhaust holes 20. As such, it is realized that the pitch between the first exhaust holes 10 and the pitch between the second exhaust holes 20 in the first direction y and/or the second direction x are different.

In further implementations, a width of the first exhaust hole 10 and a width of the second exhaust hole 20 are not equal in the first direction y and not equal in the second direction x. In the first direction y, the spacing between two adjacent first exhaust holes 10 is different from the spacing between two adjacent second exhaust holes 20; and/or in the second direction x, the spacing between two adjacent first exhaust holes 10 is different from the spacing between two adjacent second exhaust holes 20. As such, it is realized that the pitch between the first exhaust holes 10 and the pitch between the second exhaust holes 20 in the first direction y and/or the second direction x are different.

In some implementations, as shown in FIG. 3B, the pitch L4 between the first exhaust holes 10 in the first direction y and the pitch L2 between the first exhaust holes 10 in the second direction x are not equal. For example, L4 is greater than L2; and/or the pitch L3 between the second exhaust holes 20 in the first direction y and the pitch L1 between the second exhaust holes 20 in the second direction x are equal. In this implementation, the arrangement mode of the first exhaust holes 10 and the arrangement mode of the second exhaust holes 20 are different. The plurality of first exhaust holes 10 are arranged in a relatively regular array, and/or the plurality of second exhaust holes 20 are also arranged in a relatively regular array. The design of the mask used for etching the exhaust holes is simpler. Moreover, such a setting can facilitate the cooperation of the first metal layer M1 with structures of other film layers. For example, the first metal layer M1 cooperates with structures of other film layers to form a relatively tight light-shielding layer to shield transistors between the first metal layer M1 and the substrate.

In some implementations, L3=L1, and L2<L4.

In some implementations, as shown in FIG. 3A, multiple first exhaust holes of the plurality of first exhaust holes 10 are arranged into a first hole column 10L along the first direction y, multiple first exhaust holes of the plurality of first exhaust holes 10 are arranged into a first hole row 10H along the second direction x, and two adjacent first exhaust holes 10 in the first hole row 10H belong to two adjacent first hole columns 10L. The plurality of first exhaust holes 10 on the first metal portion M11 are arranged in rows and columns. Multiple second exhaust holes of the plurality of second exhaust holes 20 are arranged into a second hole column 20L along the first direction y, and multiple second exhaust holes of the plurality of second exhaust holes 20 are arranged into a second hole row 20H along the second direction x; two adjacent second exhaust holes 20 in the second hole row 20H are spaced by at least one second hole row 20L, and/or two adjacent second exhaust holes 20 in the second hole row 20L are spaced by at least one second hole row 20H. In this implementation, the plurality of first exhaust holes 10 on the first metal portion M11 are arranged in rows and columns; and on the second metal portion M12, at least some adjacent second hole rows 20H are staggered in the first direction y, and at least some adjacent second hole columns 20L are staggered in the second direction x. As such, the arrangement mode of the plurality of first exhaust holes 10 is different from the arrangement mode of the plurality of second exhaust holes 20. Moreover, the second exhaust holes 20 are arranged in a staggered array, so that an area proportion of the exhaust holes can be made larger, which can improve the exhaust capacity, being more conducive to reducing the risk of film layer delamination.

The embodiment in FIG. 3A illustrates that in the second metal portion M12, two adjacent second exhaust holes 20 in the second hole row 20H are spaced by one second hole column 20L, and two adjacent second exhaust holes 20 in the second hole column 20L are spaced by one second hole row 20H. FIG. 4 is a partial schematic diagram of another display panel provided by an embodiment of the present disclosure, and FIG. 4 illustrates another arrangement mode of the second exhaust holes 20 on the second metal portion M12. As shown in FIG. 4, two adjacent second exhaust holes 20 in a first type of second hole row 20H-1 are spaced by two second hole columns 20L, some adjacent second exhaust holes 20 in a second type of second hole row 20H-2 are spaced by two second hole columns 20L, and some adjacent second exhaust holes 20 in the second type of second hole row 20H-2 are spaced by no second hole column 20L. That is, two adjacent second exhaust holes 20 in some of second hole rows 20H are spaced by two second hole columns 20L, and two adjacent second exhaust holes 20 in the second hole column 20L are spaced by one second hole row 20H.

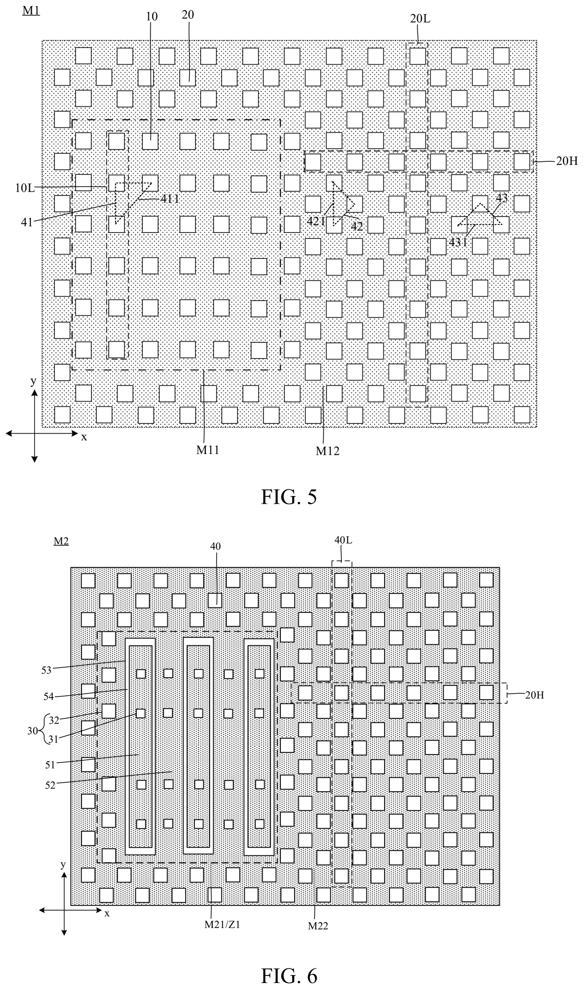

In further implementations, FIG. 5 is a partial schematic diagram of another display panel provided by an embodiment of the present disclosure, and FIG. 5 illustrates one first metal portion M11 and a part of the second metal portion M12 connected to the first metal portion M11 in the first metal layer M1. As shown in FIG. 5, multiple first exhaust holes of the plurality of first exhaust holes 10 are arranged into a first hole column 10L along the first direction y, and three adjacent first exhaust holes 10 belonging to two adjacent first hole columns 10L form a first triangle 41, which is a right triangle. A longest side of the first triangle 41 is a first side 411, and an extension direction of the first side 411 intersects the first direction y and the second direction x. Three adjacent first exhaust holes 10 mean that any two of the three first exhaust holes 10 are adjacent to each other. Multiple second exhaust holes of the plurality of second exhaust holes 20 are arranged into a second hole column 20L along the first direction y, three adjacent second exhaust holes 20 belonging to two adjacent second hole columns 20L form a second triangle 42, a longest side of the second triangle 42 is a second side 421, and the second side 421 extends along the first direction y; and/or, multiple second exhaust holes of the plurality of second exhaust holes 20 are arranged into a second hole row 20H along the second direction x, three adjacent second exhaust holes 20 belonging to two adjacent second hole rows 20H form a third triangle 43, a longest side of the third triangle 43 is a third side 431, and the third side 431 extends along the second direction x. As such, the arrangement mode of the plurality of first exhaust holes 10 is made different from the arrangement mode of the plurality of second exhaust holes 20. Three adjacent first exhaust holes 10 mean that any two of the three first exhaust holes 10 are adjacent to each other, and three adjacent second exhaust holes 20 means that any two of the three second exhaust holes 20 are adjacent to each other.

In some implementations, the first triangle 41 is a right triangle, and lengths of two right-angle sides of the first triangle 41 are not equal.

In some implementations, the second triangle 42 is an isosceles triangle, and the third triangle 43 is an isosceles triangle.

Further, in some implementations, the second triangle 42 and the third triangle 43 are isosceles right triangles, respectively.

In some implementations, as shown in FIG. 3A, an arrangement density of the first exhaust holes 10 is less than an arrangement density of the second exhaust holes 20. The density of the exhaust holes is set in cooperation with the structural differences of other film layers at the positions of the first metal portion M11 and the second metal portion M12, and the arrangement density of the second exhaust holes 20 in the second metal portion M12 is relatively larger, so that it is easier for the gas generated during the fabrication process to be exhausted through the second exhaust holes 20. The arrangement density of the first exhaust hole 10 in the first metal portion M11 is relatively smaller, for example, the first metal portion M11 can cooperate with structures in other metal layers so that a relatively tighter light shielding layer is formed in an area where the first metal portion M11 is located, which can prevent a ray of light from entering the transistors below through the area where the first metal portion M11 is located to cause leakage current, thereby ensuring stable characteristics of the transistors.

The arrangement density of the exhaust holes is defined by the number of the exhaust holes per unit area. For example, the number of the second exhaust holes 20 provided per unit area is greater than the number of the first exhaust holes 10 provided per unit area.

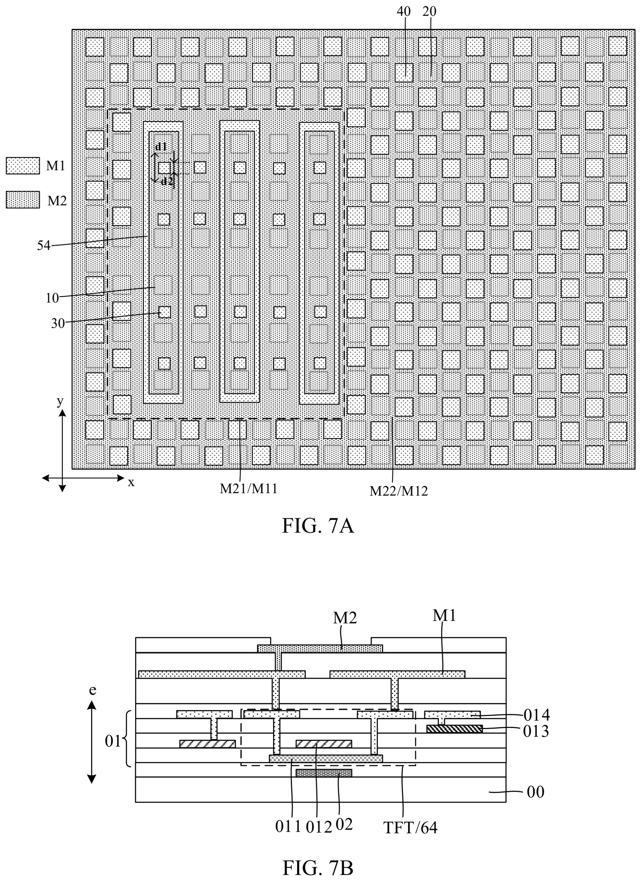

In some implementations of the present disclosure, the display panel further includes a second metal layer located on one side of the substrate, and the second metal layer and the first metal layer are located in different layers. FIG. 6 is a schematic diagram of another display panel provided by an embodiment of the present disclosure, and FIG. 6 illustrates positions of a third metal portion and a fourth metal portion in the second metal layer. FIG. 7A is a schematic diagram of another display panel provided by an embodiment of the present disclosure, and FIG. 7A is a top view of an overlapping region of the first metal layer and the second metal layer.

As shown in FIG. 6, the second metal layer M2 includes the third metal portion M21, and the third metal portion M21 includes a plurality of third exhaust holes 30. As can be seen from the top view of FIG. 7A, along a direction perpendicular to the plane of the substrate, the third metal portion M21 and the first metal portion M11 overlap, and the third exhaust holes 30 and the first exhaust holes 10 at least partially do not overlap. The third gas exhaust holes 30 are provided on the third metal portion M21 of the second metal layer M2, can be used to reduce the pressure drop of a signal transmitted by the second metal layer M2 when the second metal portion M21 has a large area, and can be used to exhaust the gas generated during the fabrication process to prevent film layer delamination of the third metal portion M21. In addition, by the setting that the third exhaust holes 30 and the first exhaust holes 10 at least partially do not overlap, a relatively tighter light shielding layer can be formed in the overlapping region of the third metal portion M21 and the first metal portion M11, which can prevent leakage current caused by a ray of light entering the transistors below through the regions where the third metal portion M21 and the first metal portion M11 are located, thereby being capable of ensuring stable characteristics of the transistors and improving performance reliability of the display panel.

As shown in FIG. 6, the second metal layer M2 includes the fourth metal portion M22, and the fourth metal portion M22 includes a plurality of fourth exhaust holes 40. As can be seen from the top view of FIG. 7A, along the direction perpendicular to the plane of the substrate, the fourth metal portion M22 and the second metal portion M12 overlap, and the fourth exhaust holes 40 and the second exhaust holes 20 at least partially do not overlap. The fourth gas exhaust holes 40 are provided on the fourth metal portion M22 of the second metal layer M2, and can be used to reduce the pressure drop of a signal transmitted by the fourth metal portion M22 when the fourth metal portion M22 has a large area, and can be used to exhaust the gas generated during the fabrication process to prevent film layer delamination of the fourth metal portion M22. In addition, by the setting that the fourth exhaust holes 40 and the second exhaust holes 20 at least partially do not overlap, a relatively tighter light shielding layer can be formed in the overlapping region of the fourth metal portion M22 and the second metal portion M12, which can prevent leakage current caused by a ray of light entering the transistors below through the regions where the fourth metal portion M22 and the second metal portion M12 are located, thereby ensuring stable characteristics of the transistors and ensuring reliable performance of the display panel.

FIG. 7B is a schematic diagram of a film layer structure of another display panel provided by an embodiment of the present disclosure. As shown in FIG. 7B, the display panel includes a substrate 00, a driving layer 01 located on the substrate 00, a first metal layer M1 and a second metal layer M2 located on one side of the driving layer 01 away from the substrate 00. The driving layer 01 includes a pixel circuit 64. One transistor TFT in the pixel circuit 64 is marked out in FIG. 7B. The driving layer 01 includes a semiconductor layer 011, a gate metal layer 012, an electrode metal layer 013, and a source-drain metal layer 014. The active layer of the transistor TFT is located in the semiconductor layer 011. A light shielding layer 02 is further provided between the semiconductor layer 011 and the substrate 00. In the direction e perpendicular to the plane of the substrate 00, the light shielding layer 02 overlaps the active layer of the transistor TFT. The light shielding layer 02 is used to shield the active layer of the transistor TFT from light on the side of the substrate 00, thereby preventing a ray of light from irradiating the active layer to affect the performance of the transistor TFT. A gate of the transistor TFT is located in the gate metal layer 012. A first plate of a storage capacitor is provided in the electrode metal layer 013, and a second plate of the storage capacitor is located in the gate metal layer 012. A source and a drain of the transistor TFT are at least partially provided in the source-drain metal layer 014.

In some implementations, as shown in FIG. 7B, the first metal layer M1 is located on one side of the second metal layer M2 close to the substrate 00, and the pixel circuit 64 is provided between the first metal layer M1 and the substrate 00. The light-emitting elements 60 are provided on one side of the second metal layer M2 away from the first metal layer M1. That is, the second metal layer M2 is closer to the light-emitting elements 60 than the first metal layer M1. A positive power supply structure for transmitting a positive power supply signal can be provided in the first metal layer M1, and a negative power supply structure for transmitting a negative power supply signal can be provided in the second metal layer M2. The positive power supply structure and the negative power supply structure are both provided as metal structures with large areas, so that the voltage drops of the transmitted power supply signals can be reduced and the display uniformity can be improved. In addition, the arrangement mode of the exhaust holes at different positions is reasonably set in cooperation with the positions of the large area metals, so that the gas generated during the fabrication process of the display panel can be exhausted through the exhaust holes, thereby preventing the film layer delamination phenomenon of the large area metals.

As shown in FIG. 6, multiple fourth exhaust holes of the plurality of fourth exhaust holes 40 are arranged into a third hole column 40L along the first direction y, a plurality of fourth exhaust holes 40 are arranged into a third hole row 40H along the second direction x, two adjacent fourth exhaust holes 40 in the third hole row are spaced by at least one third hole column 40L, and two adjacent fourth exhaust holes 40 in the third hole column 40L are spaced by at least one third hole row 40H. The arrangement mode of the fourth exhaust holes 40 in FIG. 6 is similar to the arrangement mode of the second exhaust holes 20 illustrated in FIG. 3A, two adjacent fourth exhaust holes 40 in the third hole row are spaced by one third hole column 40L, and two adjacent fourth exhaust holes 40 in the third hole column 40L are spaced by one third hole row 40H. The fourth exhaust holes 40 are arranged in a staggered array, so that the area proportion of the exhaust holes can be made larger, which can improve the exhaust capacity, being more conducive to reducing the risk of film layer delamination.

It can be seen from FIG. 7A that an orthographic projection of the fourth exhaust hole 40 on the substrate is located in a region surrounded by orthographic projections of four adjacent second exhaust holes 20 on the substrate, and an orthographic projection of the second exhaust hole 20 on the substrate is located in a region surrounded by orthographic projections of four adjacent fourth exhaust holes 40 on the substrate. The adjacent four second exhaust holes 20 refer to that any two of these four second exhaust holes 20 are adjacent to each other, and the adjacent four fourth exhaust holes 40 refer to that any two of these four fourth exhaust holes 40 are adjacent to each other. In this implementation, the second exhaust hole 20 and the fourth exhaust hole 40 do not overlap, so that the overlapping region of the second metal portion M12 and the fourth metal portion M22 forms a relatively tight light shielding layer, which can prevent a ray of light from entering the transistors below through the regions where the fourth metal portion M22 and the second metal portion M12 are located to cause leakage current, thereby being capable of ensuring stable characteristics of the transistors and reliable performance of the display panel.

In the display panel, the fourth metal portion M22 in the second metal layer M2 overlaps the second metal portion M12 in the first metal layer M1. During the design of the display panel, the second exhaust holes 20 in the second metal portion M12 are first designed to be arranged in an array, and the arrangement mode of the fourth exhaust holes 40 in the fourth metal portion M22 is designed according to the positions of the second exhaust holes 20, so that the second exhaust holes 20 and the fourth exhaust holes 40 do not overlap, and a relatively tight light shielding layer is formed in the overlapping region of the second metal portion M12 and the fourth metal portion M22.

In some implementations, as shown in FIG. 6, the display panel includes the second metal layer M2. The second metal layer M2 and the first metal layer M1 are located in different layers. The second metal layer M2 includes the third metal portion M21. Along the direction perpendicular to the plane of the substrate, the third metal portion M21 and the first metal portion M11 overlap. The third metal portion M21 includes the third exhaust holes 30. The third metal portion M21 includes first electrodes 51 and second electrodes 52. The third metal portion M21 has first grooves 53. The first electrodes 51 are located in the first grooves 53. The second electrode 52 and at least one first groove 53 share at least one side wall. For example, the first electrodes 51 serve as anodes, and the second electrodes 52 serve as cathodes. At least a part of the third metal portion M21 is located in the pixel region Z1. Three first electrodes 51 and three second electrodes 52 are provided in one pixel region Z1. As illustrated in FIG. 6, the first electrodes 51 and the second electrodes 52 are alternately arranged in the second direction x, one second electrode 52 and one first groove 53 share a side wall, and the other two second electrodes 52 and two first grooves 53 share two side walls, respectively. The first grooves 53 penetrate the second metal layer M2 in a thickness direction of the second metal layer M2. The first grooves 53 also have an exhaust function. However, the first grooves 53 are arranged to accommodate the first electrodes 51, so that the first electrodes 51 and the second electrodes 52 are manufactured in the same layer and insulated from each other. Therefore, an area of the first groove 53 is larger than the area of the third exhaust hole 30.

In an embodiment of the present disclosure, the third exhaust holes 30 and the first exhaust holes 10 at least partially do not overlap along the direction perpendicular to the plane of the substrate. Since the region where the third metal portion M21 in the second metal layer M2 is located is provided with the first grooves 53 and the second electrodes 52, the third exhaust holes 30 are appropriately provided on the second electrodes 52. During the design of the display panel, the arrangement mode of the exhaust holes in the first metal layer M1 is first designed, and then the positions of the first exhaust holes 10 in the first metal portion M11 are appropriately adjusted according to the arrangement mode of the second electrodes 52 in the third metal portion M21 and the positions of the third exhaust holes 30, so as to ensure that the light-shielding effect of the light shielding layer formed by overlapping the first metal portion M11 and the third metal portion M21 is better. For example, the positions of the first exhaust holes 10 are appropriately adjusted, so that the pitch L4 between the first exhaust holes 10 in the first direction y and the pitch L2 between the first exhaust holes 10 in the second direction x are not equal, and/or the pitch L3 between the second exhaust holes 20 in the first direction y and the pitch L1 between the second exhaust holes 20 in the second direction x are equal.

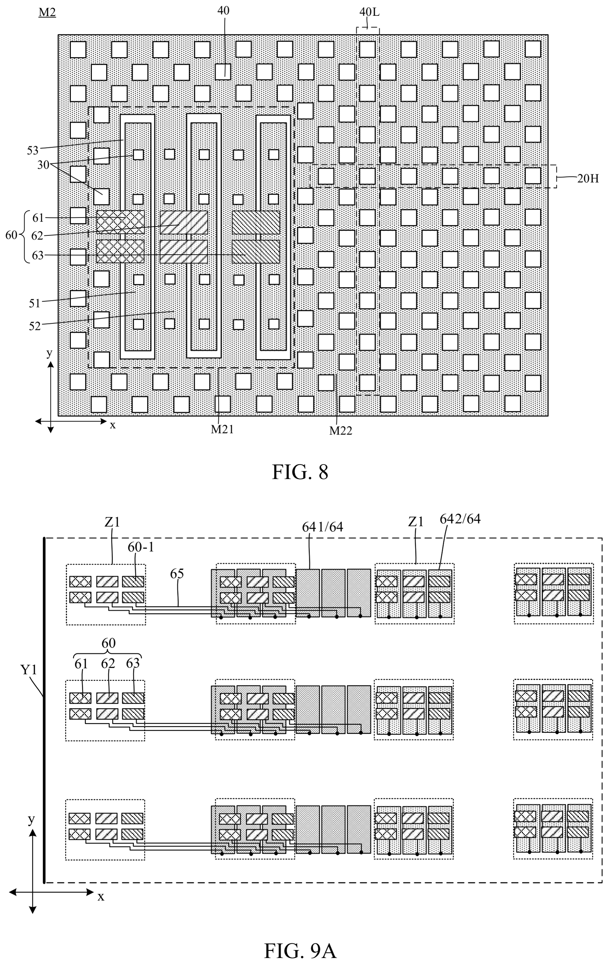

FIG. 8 is a schematic diagram of another display panel provided by an embodiment of the present disclosure, and FIG. 8 illustrates a local area of the second metal layer M2 and the light-emitting elements 60 respectively bound to the first electrodes 51 and the second electrodes 52. As shown in FIG. 8, the light-emitting elements 60 includes red light-emitting elements 61, green light-emitting elements 62, and blue light-emitting elements 63. As can be seen from the top view of FIG. 8, along the direction perpendicular to the plane of the substrate, one end of the light-emitting element 60 overlaps one first electrode 51, the other end of the light-emitting element 60 overlaps one second electrode 52, and the light-emitting elements 60 and the third exhaust holes 30 do not overlap. The light-emitting elements 60 are correspondingly connected to the first electrodes 51 and the second electrodes 52 located in the second metal layer M2. The setting that the light-emitting elements 60 and the third exhaust holes 30 do not overlap can not only ensure that the overlapping areas of the light-emitting elements 60 and the first electrodes 51/the second electrodes 52 are large enough and the connection impedances are low, but also the overlapping positions of the light-emitting elements 60 and the first electrodes 51/the second electrodes 52 are relatively more flat, which is beneficial to improving the yield of the bonding process.

In conjunction with the overlapping condition of the first metal layer M1 and the second metal layer M2 illustrated in FIG. 7A, the light-emitting elements 60 and the first exhaust holes 10 in the first metal portion M11 may partially overlap. This is because the first metal layer M1 is located on the side of the second metal layer M2 close to the substrate 00, and an organic insulating layer is further provided between the first metal layer M1 and the second metal layer M2, so that the partial overlapping of the light-emitting elements 60 and the first exhaust holes 10 will not affect the flatness of the light-emitting elements 60 and the electrode bonding areas.

In some implementations, as shown in FIG. 6, a first gap 54 is formed between the first electrode 51 and the side wall of the first groove 53 that accommodates the at least one first electrode. In conjunction with the top view of FIG. 7A, along the direction perpendicular to the plane of the substrate, the first exhaust hole 10 and the first gap 54 do not overlap. That is, the first gap 54 and the solid portion on the first metal portion M11 overlap. By such a setting, the light shielding layer can be formed at the overlapping position of the first gap 54 and the first metal portion M11, so that the area of an opaque region formed by overlapping the first metal layer M1 and the second metal layer M2 is larger, which is more conducive to preventing a ray of light from entering the transistors below through the overlapping region of the first metal layer M1 and the second metal layer M2.

As shown in FIG. 7A, in the first direction y, the spacing between two adjacent first exhaust holes 10 is d1, and a width of the third exhaust hole 30 is d2; and d1 > d2. Such a setting can make an orthographic projection of the third exhaust hole 30 on the plane of the substrate located between the orthographic projections of two adjacent first exhaust holes 10 on the plane of the substrate, and make the third exhaust hole 30 and the first exhaust hole 10 not overlap. As such, the area of the opaque region formed by overlapping the first metal layer M1 and the second metal layer M2 is larger, which is more conducive to preventing a ray of light from entering the transistors below through the overlapping region of the first metal layer M1 and the second metal layer M2.

In conjunction with FIGS. 6 and 7A, the first electrodes 51 and at least one of the second electrodes 52 each include third exhaust holes 30. A width of the second electrode 52 between two adjacent first grooves 53 in the second direction x is greater than the width of the first exhaust hole 10 in the second direction x, and/or a width of the first electrode 51 in the second direction x is greater than the width of the first exhaust hole 10 in the second direction x. Such a setting can make the third exhaust hole 30 and the first exhaust hole 10 not overlap, so that the opaque region formed by overlapping the first metal layer M1 and the second metal layer M2 is larger, which is more conducive to preventing a ray of light from entering the transistors below through the overlapping region of the first metal layer M1 and the second metal layer M2.

In some implementations, as shown in FIG. 6, the second metal layer M2 includes the fourth metal portion M22, which is connected to the third metal portion M21 and at least partially surrounds the third metal portion M21. Along the direction perpendicular to the plane of the substrate, the fourth metal portion M22 and the second metal portion M12 overlap. The fourth metal portion M22 includes a plurality of fourth exhaust holes 40. Specifically, the fourth metal portion M22 is electrically connected to the second electrodes 52 in the third metal portion M21. The third metal portion M21 is at least partially located in the pixel region Z1, and the fourth metal portion M22 is at least partially located in the non-pixel region Z2. In this implementation, the second metal layer M2 is a metal layer with a large area, which can reduce a voltage drop of a signal transmitted by the fourth metal portion M22 and improve the display uniformity. Moreover, the third metal portion M21 and the fourth metal portion M22 are each provided with exhaust holes arranged in different modes, which can reduce the risk of film layer delamination of large area metal and improve the product performance reliability.

As shown in FIG. 6, an area of at least one third exhaust hole 30 is less than an area of the fourth exhaust hole 40. The area of the exhaust hole refers to an area of an orthographic projection of the exhaust hole on the plane of the substrate. Since the third metal portion M21 includes the first electrodes 51 and the second electrodes 52, it is necessary to adapt to the shapes of the first electrodes 51 and the second electrodes 52 to design the positions and areas of the third exhaust holes 30, so as to ensure the exhaust capability at the position of the third metal portion M21. In addition, the area of at least a part of the third exhaust holes 30 is set to be relatively small, which is also beneficial to matching with the area of the first exhaust holes 10 in the first metal portion M11, so that the third exhaust holes 30 and the first exhaust holes 10 do not overlap, which is beneficial to shielding the transistors in the display panel.

As shown in FIG. 6, the third exhaust hole 30 includes a first type of third exhaust holes 31, some of the first type of third exhaust holes 31 are located on the first electrodes 51, and some of the first type of third exhaust holes 31 are located on the second electrode 52 provided between two adjacent first electrodes 51. Optionally, the third exhaust hole 30 further includes a second type of third exhaust holes 32. The second type of third exhaust holes 32 are located on the second electrode 52 located at an edge of the third metal portion M21. In other words, the second electrode 52 is adjacent to only one first electrode 51. The second type of third exhaust holes 32 are located at the edge of the third metal portion M21, that is, the second type of third exhaust holes 32 are adjacent to the fourth metal portion M22. Therefore, an area of the second type of third exhaust hole 32 may be set to be different from an area of the first type of third exhaust hole 31. For example, an area of the second type of third exhaust hole 32 is set to be the same as the area of the fourth exhaust hole 40.

In addition, as illustrated in FIG. 6, the first electrodes 51 and the second electrodes 52 are adjacent to each other in the second direction x. In further implementations, the first electrodes 51 and the second electrodes 52 are adjacent to each other in the first direction y, which is no longer illustrated herein in the accompanying drawings.

In some implementations, FIG. 9A is a schematic diagram of another display panel provided by an embodiment of the present disclosure. As shown in FIG. 9A, the display panel includes a first edge Y1 extending along the first direction y. The pixel region Z1 includes a red light-emitting element 61, a green light-emitting element 62, and a blue light-emitting element 63. The display panel is further provided with a pixel circuit 64 electrically connected to the red light-emitting element 61, the green light-emitting element 62, and the blue light-emitting element 63, respectively. FIG. 9A illustrates a plurality of pixel regions Z1, and the region outside the pixel regions Z1 is a non-pixel region. It is illustrated in FIG. 9A that one pixel region Z1 is provided with two red light-emitting elements 61, two green light-emitting elements 62, and two blue light-emitting elements 63. One pixel region Z1 corresponds to one pixel circuit 64. FIG. 9A illustrates that the pixel circuit 64 includes a first pixel circuit 641 and a second pixel circuit 642. The first pixel circuit 641 is staggered with the light-emitting elements 60 connected thereto. The second pixel circuit 642 and the light-emitting elements 60 connected thereto at least partially overlap in the direction perpendicular to the plane of the substrate.

FIG. 9A illustrates a redundant design in the pixel region Z1. For example, one of the two red light-emitting elements 61 is a redundant design. One red light-emitting element 61 is first fixed in one pixel region Z1. When it is detected that this red light-emitting element 61 has a defect and cannot emit light, another red light-emitting element 61 is fixed for repair. The previously fixed red light-emitting element 61 remains at its original position, so that there are two red light-emitting elements 61 in one pixel region Z1. The green light-emitting element 62 and the blue light-emitting element 63 adopt the same repair method, and finally, there may be two red light-emitting elements 61, two green light-emitting elements 62, and two blue light-emitting elements 63 in one pixel region Z1. For example, when only one red light-emitting element 61 is repaired, finally, there are two red light-emitting elements 61, one green light-emitting element 62, and one blue light-emitting element 63 in one pixel region Z1.

In further implementations, one pixel region Z1 is provided with one red light-emitting element 61, one green light-emitting element 62, and one blue light-emitting element 63. During manufacturing, one red light-emitting element 61 is first fixed in one pixel region Z1, and when it is detected that this red light-emitting element 61 has a defect and cannot emit light, the defective light-emitting element is removed, and then one red light-emitting element 61 is fixed in situ for repair. As such, finally, there is one red light-emitting element 61 in one pixel region Z1. The green light-emitting element 62 and the blue light-emitting element 63 adopt the same repair method, and finally, there is one red light-emitting element 61, one green light-emitting element 62, and one blue light-emitting element 63 in one pixel region Z1.

The light-emitting elements 60 in the display panel includes first light-emitting elements 60-1 electrically connected to the first pixel circuit 641. It can be seen from FIG. 9A that orthographic projections of the first light-emitting elements 60-1 on the substrate and an orthographic projection of the first pixel circuit 641 on the substrate are staggered in the first direction y and/or the second direction x. The first light-emitting elements 60-1 are electrically connected to the first pixel circuit 641 through connection lines 65. The orthographic projections of the light-emitting elements 60 and the orthographic projection of the pixel circuit 64 do not overlap in the first direction y, and do not overlap in the second direction x. For example, the first direction y is the column direction, and the second direction x is the row direction. When the pixel circuits 64 are retracted inwards along the first direction y relative to edges of the display panel, that is, when the pixel circuits 64 at an upper edge and an lower edge are retracted inwards, the light-emitting elements and the pixel circuit connected thereto do not overlap in the second direction x. When the pixel circuits 64 are retracted inwards along the second direction x relative to edges of the display panel, that is, when the pixel circuits 64 at a left edge and a right edge are retracted inwards, the light-emitting elements and the pixel circuit connected thereto do not overlap in the first direction y. The pixel circuits are retracted inwards along the first direction y relative to one edge of the display panel and are retracted inwards along the second direction x relative to another edge of the display panel, the light-emitting elements and the pixel circuit connected thereto do not overlap in the second direction x and the first direction y.

As shown in FIG. 9A, the first pixel circuits 641 are retracted inwards along a direction away from the first edge Y1 in the second direction x relative to the first edge Y1, so that other structures such as shift registers and the like provided at an edge position can also be retracted inwards relative to the first edge Y1. If the shift registers are provided to at least partially overlap the light-emitting elements 60, it is equivalent to providing at least a part of the shift registers in the display area, which can reduce the area of the non-display area and narrow the bezel.

In FIG. 9A, the first pixel circuits 641 near the first edge Y1 are retracted inwards along the direction away from the first edge Y1 in the second direction x, so that the first pixel circuits 641 and the first light-emitting elements 60-1 connected thereto are staggered at least in the first direction y, and the first pixel circuits 641 and the first light-emitting elements 60-1 connected thereto are still located in the same pixel row. The embodiment in FIG. 9A can narrow the left and right bezels of the display panel.

In further implementations, the display panel further includes a second edge extending along the second direction x, and at least a part of the pixel circuits near the second edge are retracted inwards along a direction away from the second edge in the first direction y, so that the pixel circuits and the light-emitting elements connected thereto are staggered at least in the second direction x, and the staggered pixel circuits and the light-emitting elements connected thereto are not located in the same pixel row. In this solution, the staggered pixel circuits and the light-emitting elements also need to be electrically connected to each other through connection lines. In this implementation, the upper bezel and/or the lower bezel of the display panel can be narrowed.

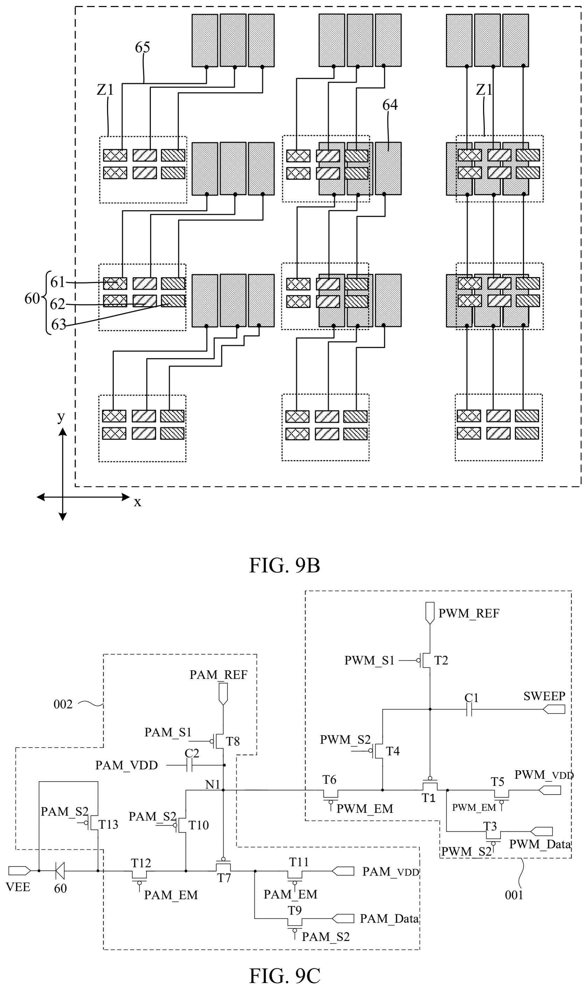

In some implementations, FIG. 9B is a schematic diagram of another display panel provided by an embodiment of the present disclosure. In a partial area of the display panel as illustrated in FIG. 9B, the light-emitting elements 60 located in the pixel regions Z1 in the first column and the second column from the left and the pixel circuits 64 connected thereto are staggered in the first direction y and are staggered in the second direction x, and the light-emitting elements 60 located in the pixel regions Z1 in the third column from the left and the pixel circuits 64 connected thereto are staggered in the second direction x. In this implementation, the pixel circuits 64 corresponding to the pixel regions Z1 in the first column and the second column from the left are retracted inwards in the first direction y and the second direction x, and the pixel circuits 64 corresponding to the pixel regions Z1 in the third column from the left are retracted inwards in the first direction y.

The pixel circuit 64 in the embodiments of the present disclosure may be anyone in the prior art.

In an embodiment, the pixel circuit 64 is an aTbC pixel circuit, including a transistors and b capacitors, where a and b are positive integers. For example, the pixel circuit 64 is a 7T1C pixel circuit. Optionally, the first metal layer M1 is configured to transmit a positive power supply voltage, and the second metal layer M2 is configured to transmit a negative power supply voltage.

In an embodiment, the pixel circuit 64 includes a pulse amplitude modulation (PAM) circuit and a pulse width modulation (PWM) circuit. FIG. 9C is a diagram of a pixel circuit provided by an embodiment of the present disclosure. As shown in FIG. 9C, the pixel circuit includes a first driving circuit 001 and a second driving circuit 002. The first driving circuit 001 is configured to control a duration of providing a driving current to a light-emitting element 60 based on a first data voltage PWM-data. The second driving circuit 002 is configured to control an amplitude of providing the driving current to the light-emitting element 60 based on a second data voltage PAM-data.

The first driving circuit 001 includes a first driving transistor T1, a first gate reset transistor T2, a first data writing transistor T3, a first compensation transistor T4, a first control transistor T6, a second control transistor T5, and a first capacitor C1. The first capacitor C1 is a storage capacitor in the first driving circuit 001, and may also be referred to as a first storage capacitor in the pixel circuit. The second control transistor T5 is connected between a first power supply voltage PWM-VDD and a first electrode of the second driving transistor T1, and the first control transistor T6 is connected between a second electrode of the first driving transistor T1 and a first node N1. The first data writing transistor T3 is connected to the first electrode of the first driving transistor T1, the first compensation transistor T4 is connected to the second electrode of the first driving transistor T1 and a gate of the first driving transistor T1, and the first gate reset transistor T2 is connected to the gate of the first driving transistor T1. A first plate of the first capacitor C1 is connected to the gate of the first driving transistor T1, and a second plate of the first capacitor C1 is connected to a sweep frequency signal SWEEP. A gate of the first gate reset transistor T2 is connected to a third sweep signal PWM-S1, and a gate of the first data writing transistor T3 and a gate of the first compensation transistor T4 are connected to a fourth sweep signal PWM-S2. A gate of the first control transistor T6 and a gate of the second control transistor T5 are connected to a first light-emitting control signal PWM-EM.

The second driving circuit 002 includes a second driving transistor T7, a second gate reset transistor T8, a second data writing transistor T9, a second compensation transistor T10, a third control transistor T11, a fourth control transistor T12, an electrode reset transistor T3, and a second capacitor C2. The second capacitor C2 is a second storage capacitor in the pixel circuit. The third control transistor T11 is connected between a second power supply voltage PAM-VDD and a first electrode of the second driving transistor T7, and the fourth control transistor T12 is connected between a second electrode of the second driving transistor T7 and the light-emitting element 60. The second driving transistor T7 is configured to generate the driving current under the control of a gate voltage thereof, and a gate of the second driving transistor T7 is connected to the first node N1. The second data writing transistor T9 is connected to the first electrode of the second driving transistor T7, the second compensation transistor T10 is connected to the second electrode and the gate of the second driving transistor T7, the second gate reset transistor T8 is connected to the gate of the second driving transistor T7, the electrode reset transistor T13 is connected to a first electrode of the light-emitting element 60, the fourth control transistor T12 is also connected to the first electrode of the light-emitting element 60, and a second electrode of the light-emitting element 60 is connected to a third power supply voltage VEE. A gate of the second gate reset transistor T8 is connected to a first sweep signal PAM-S1. A gate of the second data writing transistor T9, a gate of the second compensation transistor T10, and a gate of the electrode reset transistor T13 are connected to a second sweep signal PAM-S2. A gate of the third control transistor T11 and a gate of the fourth control transistor T12 are connected to a second light emission control signal PAM-EM.

When the pixel circuit provided in FIG. 9C is used in the display panel, power supply structures need to be provided to provide the PAM-VDD and the PWM-VDD, respectively. Optionally, the display panel includes a first metal layer M1, a second metal layer M2, and a third metal layer, the second metal layer M2 is located on one side of the first metal layer M1 away from a substrate, and the third metal layer is located on one side of the first metal layer M1 close to the substrate. The first metal layer M1 and the second metal layer M2 adopt the design of nearly full-surface metal provided by the embodiments of the present disclosure, a power supply structure is manufactured in the third metal layer to provide the PWM-VDD, a power supply structure is manufactured in the first metal layer M1 to provide the PAM-VDD, and a power supply structure is manufactured in the second metal layer M2 to provide the negative power supply voltage. The third metal layer may be the source-drain metal layer 014 shown in FIG. 7B.

In another implementation, the PAM-VDD and the PWM-VDD are the same voltage, so that a positive power supply structure may be manufactured in the first metal layer M1 to provide the PAM-VDD and the PWM-VDD, and a power supply structure may be manufactured in the second metal layer M2 to provide the negative power supply voltage.

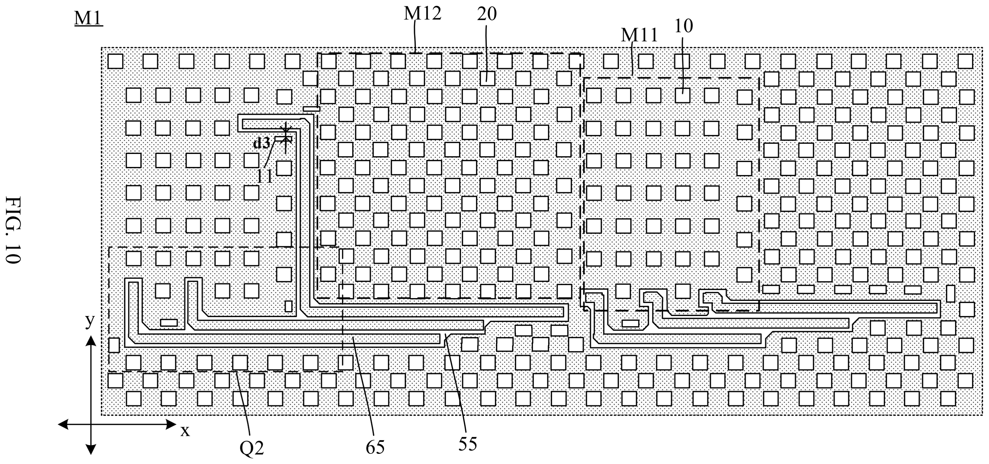

In some implementations, FIG. 10 is a schematic diagram of another display panel provided by an embodiment of the present disclosure, and FIG. 10 illustrates a partial position of the first metal layer M1. In conjunction with FIG. 9A, the display panel includes connection lines 65, pixel circuits 64, and light-emitting elements 60. One end of the connection line 65 is connected to one of the pixel circuits 64, and the other end of the connection line 65 is connected to one of the light-emitting elements 60. As shown in FIG. 10, the first metal layer M1 includes a second groove 55, and the connection lines 65 are located in the second groove 55. The connection lines 65 and the first metal layer M1 are in the same layer, one end of the connection line 65 is connected to one of the pixel circuits 64, and the other end of the connection line 65 is connected to one of the light-emitting elements 60. In this implementation, the second groove 55 is formed in the first metal layer M1, and the connection lines 65 are formed in the second groove 55, so that the surface integrity of the structure of the first metal layer M1 can be ensured to the greatest extent. When the first metal portion M11 and the second metal portion M12 in the first metal layer M1 are used to transmit a power supply signal, the voltage drop can be reduced to a large extent, and the display uniformity can be improved.

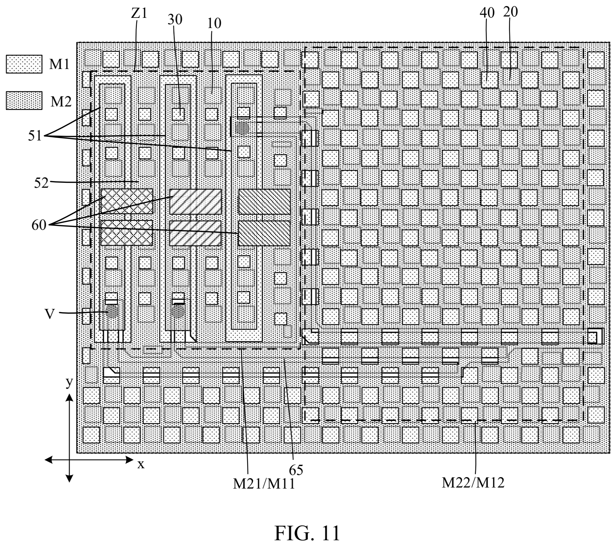

In some implementations, FIG. 11 is a schematic diagram of another display panel provided by an embodiment of the present disclosure, and FIG. 11 illustrates a top view of the stacking of the first metal layer M1 and the second metal layer M2 at an edge position of the display panel. The structure of the first metal layer M1 can be understood with reference to FIG. 10, and the structure of the second metal layer M2 can be understood with reference to the embodiment of FIG. 6. As shown in FIG. 11, the display panel includes the first metal layer M1 and the second metal layer M2, and the first metal layer M1 is located on one side of the second metal layer M2 close to the substrate. The first metal layer M1 includes the first metal portion M11 and the second metal portion M12. The second metal layer M2 includes the third metal portion M21 and the fourth metal portion M22. As can be seen from the top view of FIG. 11, along the direction perpendicular to the plane of the substrate, the third metal portion M21 and the first metal portion M11 overlap, and the fourth metal portion M22 and the second metal portion M12 overlap. In conjunction with FIG. 6, the third metal portion M21 includes the first grooves 53 and the first electrodes 51, and the first electrodes 51 are located in the first grooves 53. FIG. 11 illustrates that one end of the connection line 65 overlaps one of the first electrodes 51 along the direction perpendicular to the plane of the substrate, and the two are connected to each other through a via hole V.

No pixel circuit is shown in FIG. 11. In fact, the other end of the connection line 65 is connected to one pixel circuit. In addition, it can be seen from FIG. 11 that along the direction perpendicular to the plane of the substrate, the first exhaust holes 10 and the third exhaust holes 30 at least partially do not overlap, and the second exhaust holes 20 and the fourth exhaust holes 40 at least partially do not overlap. FIG. 11 further illustrates the light-emitting elements 60. Along the direction perpendicular to the plane of the substrate, one end of the light-emitting element 60 is electrically connected to one of the first electrodes 51 in an overlapping manner, and the other end of the light-emitting element 60 is electrically connected to one of the second electrodes 52 in an overlapping manner.

FIG. 11 illustrates three first electrodes 51, three second electrodes 52, and three color light-emitting elements 60 located in one pixel region Z1. In this embodiment, the first electrodes 51 extend in the first direction y, and the first electrodes 51 and the second electrodes 52 are alternately arranged in the second direction x. Two connection lines 65 are electrically connected to two first electrodes 51 in an overlapping manner below the two first electrodes 51, and another connection line 65 is electrically connected to one first electrode 51 in an overlapping manner above the one first electrode 51. In application, the connection lines 65 can be appropriately provided according to the staggered relationship between the pixel circuit and the corresponding light-emitting elements. According to wiring requirements, the connection lines 65 can be provided to be electrically connected to the first electrodes 51 in an overlapping manner below the first electrodes 51, or the connection lines 65 can be provided to be electrically connected to the first electrodes 51 in an overlapping manner above the first electrodes 51.

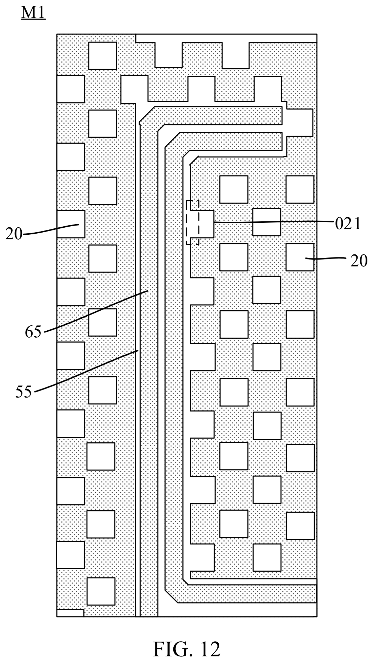

FIG. 12 is a layout design diagram of a first metal layer of another display panel provided by an embodiment of the present disclosure. FIG. 12 illustrates a partial position in the first metal layer M1. As shown in FIG. 12, the second groove 55 is designed in the display panel, the connection lines 65 are provided in the second groove 55, and the connection lines 65 are used for connecting the first electrodes 51 and the pixel circuit, so that the positions of the connection lines 65 need to be determined according to the retracted-inwards position of the pixel circuit and the position of the first electrodes 51 in the second metal layer M2. The basic design in the first metal layer M1 is that the second exhaust holes 20 are arranged in an array, and when the second groove 55 is provided in the first metal layer M1, the second groove 55 may meet the second exhaust holes 20, causing a certain interference to the second exhaust holes 20. As shown in a region 021 in FIG. 12, the second exhaust hole 20 is a serrated opening, that is, the orthographic projection of the second exhaust hole 20 on the substrate at the position of the region 021 is a non-closed pattern. It is considered by the inventors that these serrated openings will affect the later electrostatic protection and the electrical performance of the full-surface metal of the first metal layer M1, and thus a solution for correcting the serrated openings is further proposed.

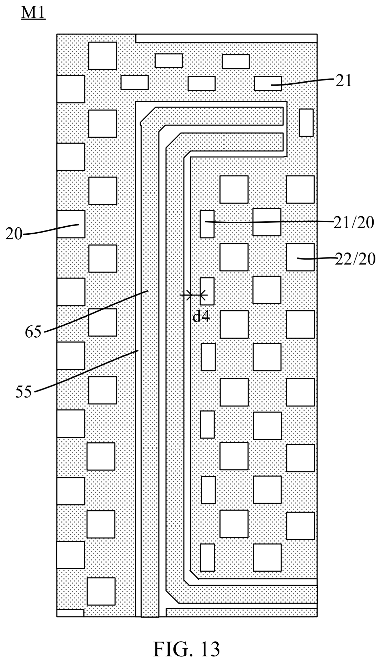

In some implementations, FIG. 13 is a partial schematic diagram of another display panel provided by an embodiment of the present disclosure, and FIG. 13 illustrates a partial position in the first metal layer M1. As shown in FIG. 13, the second exhaust holes 20 include a second exhaust sub-hole 21 adjacent to the second groove 55, and the second exhaust sub-hole 21 is not in communication with the second groove 55. The second exhaust holes 20 penetrate the first metal layer M1 in a thickness direction of the first metal layer M1. It can be seen from the top view of FIG. 13 that the shape of an orthographic projection of the second exhaust sub-hole 21 on the substrate is a closed pattern. In the embodiment of the present disclosure, the shape of the second exhaust hole 20 adjacent to the second groove 55 is corrected to avoid forming a serrated opening around the second groove 55, which can avoid affecting the electrostatic protection capability and the electrical performance of the full-surface metal of the first metal layer M1, and ensure the stable performance of the first metal layer M1 for transmitting the voltage signal.

As shown in FIG. 13, the second exhaust holes 20 include a fourth exhaust sub-hole 22, and an area of the fourth exhaust sub-hole 22 is greater than an area of the second exhaust sub-hole 21. The area comparison is performed between the areas of the orthographic projections of the exhaust holes on the plane of the substrate. In the embodiment of the present disclosure, the shape of the exhaust hole is corrected around the second groove 55 to form the second exhaust sub-hole 21, the hole area of the second exhaust sub-hole 21 is set to be small, and when the shape of the exhaust hole is corrected, only the shape of the exhaust hole, but not the position of the exhaust hole in an overall exhaust hole array, will be changed. This correction manner has little influence on the arrangement array of the second exhaust holes 20. In application, when the second exhaust holes 20 are provided so as not to overlap with the fourth exhaust holes 40 in the second metal layer M2, there is no need to change the arrangement mode of the fourth exhaust holes 40, and thus the overall design manner is simpler.

As shown in FIG. 13, a distance between the second exhaust sub-hole 21 and the second groove 55 is d4, where d4 ≥ 3 µm. Such a setting can meet the requirements of an etching process of the first metal layer M1, and ensure that the second exhaust sub-hole 21 in the first metal layer M1 manufactured by the etching process are not in communication with the second groove 55. Optionally, 15 µm ≥ d4 ≥ 3 µm.

In some implementations, 12 µm ≥ d4 ≥ 3 µm.

In some implementations, d4 ≥ 5 µm.

FIG. 13 illustrates a solution for correcting the second exhaust holes 20 in the case where the second exhaust holes 20 meet the second groove 55 to cause interference. In further implementations, as shown in FIG. 10, the first exhaust holes 10 include a first exhaust sub-hole 11 adjacent to the second groove 55, and the first exhaust sub-hole 11 is not in communication with the second groove 55. In this way, the interference caused by the first exhaust hole 10 meeting the second groove 55 can be corrected, and the first exhaust hole 10 is prevented from forming a serrated opening, which prevents the electrostatic protection capability of the first metal layer M1 and the electrical performance of the full-surface metal from being affected.

Further, as shown in FIG. 10, a distance between the first exhaust sub-hole 11 and the second groove 55 is d3,where d3 ≥ 3 µm. The magnitude of d3 meets the requirements of an etching process of the first metal layer M1, and ensures that the first exhaust sub-hole 11 in the first metal layer M1 manufactured by the etching process is not in communication with the second groove 55. Optionally, 15 µm ≥ d3 ≥ 3 µm.

Further, the first exhaust hole 10 includes a third exhaust sub-hole, and an area of the third exhaust sub-hole is greater than an area of the first exhaust sub-hole. In this way, when the shape of the first exhaust hole around the second groove 55 is corrected, only the shape of the hole, but not the position of the exhaust hole in the overall exhaust hole array, will be changed. This correction manner has little influence on the arrangement array of the first exhaust holes 10. In application, when the first exhaust holes 10 do not overlap the third exhaust holes 30 in the second metal layer M2, there is no need to change the arrangement mode of the third exhaust holes 30, and thus the overall design manner is simpler.

The display panel provided by the embodiment of the present disclosure includes the first metal layer M1 and the second metal layer M2. The first metal layer M1 includes the first metal portion M11 and the second metal portion M12, and the exhaust holes are formed in the first metal portion M11 and the second metal portion M12, respectively. The second metal layer M2 includes a third metal portion M21 and a fourth metal portion M22, and the exhaust holes are formed in the third metal portion M21 and the fourth metal portion M22, respectively. When designing the exhaust holes, the exhaust holes in the first metal portion M11 and the exhaust holes in the second metal portion M12 can be respectively designed first. When cooperating with the solution in which the connection lines 65 are provided, the second groove 55 needs to be provided. When the second groove 55 interferes with an exhaust hole, the arrangement mode of the exhaust holes in the first metal portion M11 and the second metal portion M12 is not changed as much as possible, but the positions of the exhaust holes are ensured to be unchanged by correcting the shape of the exhaust hole. Such a correction manner does not need to change the arrangement of the exhaust holes in the second metal layer M2, and the overall design of the display panel will be relatively simple. In addition, in the embodiment of the present disclosure, instead of directly removing an exhaust hole interfering with the second groove 55, the shape of the exhaust hole is corrected. As such, the area proportion of all the exhaust holes in the first metal layer M1 can be ensured, thereby avoiding affecting the overall exhaust effect.

In some implementations, an area proportion of the first exhaust holes 10 per unit area in the first metal portion M11 of the first metal layer M1 ranges from 15% to 60%, and/or an area proportion of the second exhaust holes 20 per unit area in the second metal portion M12 of the first metal layer M1 ranges from 15% to 60%.

In some implementations, the area proportion of the first exhaust holes 10 per unit area in the first metal portion M11 of the first metal layer M1 is not less than 35%, and the area proportion of the second exhaust holes 20 per unit area in the second metal portion M12 of the first metal layer M1 is not less than 35%.

In some implementations, an area proportion of the third exhaust holes 30 per unit area in the third metal portion M21 of the second metal layer M2 ranges from 15% to 60%, and/or an area proportion of the fourth exhaust holes 40 per unit area in the fourth metal portion M22 of the second metal layer M2 ranges from 15% to 60%.

In some implementations, the area proportion of the third exhaust holes 30 per unit area in the third metal portion M21 of the second metal layer M2 is not less than 35%, and/or the area proportion of the fourth exhaust holes 40 per unit area in the fourth metal portion M22 of the second metal layer M2 is not less than 35%.

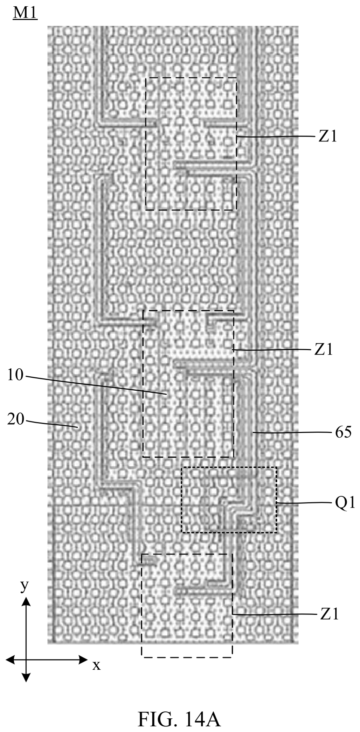

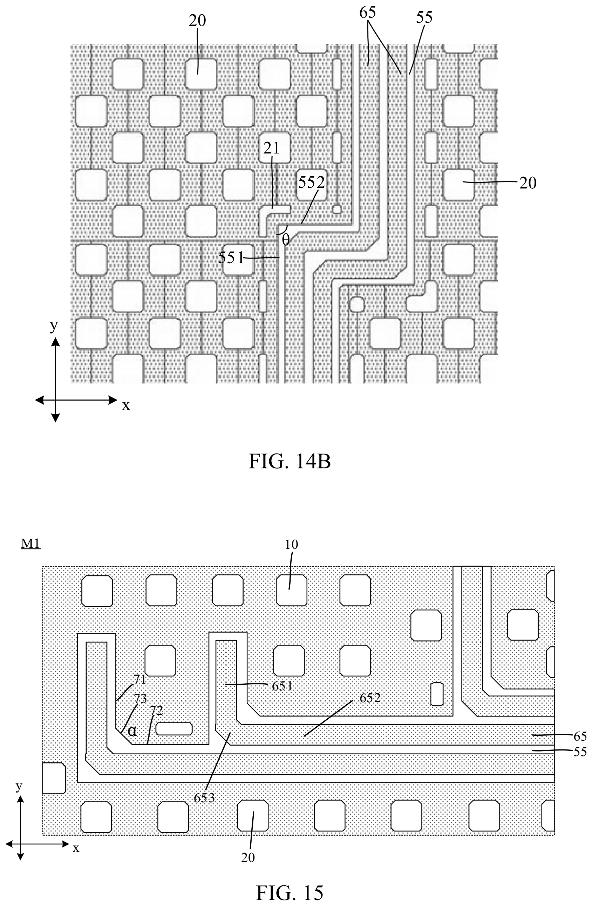

In some implementations, FIG. 14A is a schematic diagram of another display panel provided by an embodiment of the present disclosure, and FIG. 14B is an enlarged view of a region Q1 in FIG. 14A. FIG. 14A illustrates a partial position of the first metal layer M1, showing positions of three pixel regions Z1 arranged along the first direction y, and also showing the first exhaust holes 10 and the second exhaust holes 20 in the first metal layer M1, and connection lines 65. As shown in FIG. 14B, at least one second groove 55 includes a first inner wall 551 extending along the first direction y and a second inner wall 552 extending along the second direction x, and the first inner wall 551 and the second inner wall 552 are in communication with each other to form a first corner θ. The first direction y and the second direction x intersect with each other. At least one second exhaust sub-hole 21 is formed as an L-shaped second exhaust sub-hole 21 around the first corner θ. This implementation provides a manner of correcting an exhaust hole interfering with the second groove 55, and when meeting the first corner θ of the second groove 55, the second exhaust hole 21 can be designed as an L-shaped second exhaust hole 21. As such, the serrated opening can be prevented from being formed, thereby avoiding affecting the electrostatic protection capability and the electrical performance of the full-surface metal of the first metal layer M1. Moreover, the position of the second exhaust hole 20 in the overall exhaust hole array is not changed. This correction manner has little influence on the arrangement array of the second exhaust holes 20. In application, when the second exhaust holes 20 are provided so as not to overlap with the fourth exhaust holes 40 in the second metal layer M2, there is no need to change the arrangement mode of the fourth exhaust holes 40, and thus the overall design manner is simpler.

In some implementations, the first exhaust hole 10 include a first exhaust sub-hole adjacent to the second groove 55. At least one first exhaust sub-hole is formed as an L-shaped first exhaust sub-hole around the first corner θ, which is not illustrated in drawings herein. In this implementation, the first exhaust hole 10 meeting the first corner θ can be corrected to prevent the serrated opening from being formed, and the overall design of the first metal layer M1 and the second metal layer M2 can be made simpler.

In addition, it can be seen from the top view of FIG. 14B that the corners of the second exhaust hole 20 are designed as chamfers. That is, the corners of the second exhaust hole 20 with an approximately rectangular shape are not right angles. Such a design can improve the electrostatic protection performance of the first metal layer M1.

In an embodiment of the present disclosure, at least one of the first exhaust hole 10, the third exhaust hole 30, and the fourth exhaust hole 40 can be designed in a manner similar to the second exhaust hole 20 with chamfered corners in FIG. 14B.

In some implementations, FIG. 15 is a partial enlarged view of a region Q2 in FIG. 10. As shown in FIG. 15, the first metal layer M1 includes at least one first chamfer α. The first chamfer α includes a fourth side 71, a fifth side 72, and a sixth side 73; and the sixth side 73 is connected between the fourth side 71 and the fifth side 72, the fourth side 71 extends along the first direction y, and the fifth side 72 extends along the second direction x. The fourth side 71, the fifth side 72, and the sixth side 73 form a corner of the second groove 55. In this implementation, the design of the first chamfer α can prevent electrostatic concentration, improve the electrostatic protection performance of the first metal layer M1, and ensure reliable electrical performance of the full-surface metal of the first metal layer M1.

FIG. 15 illustrates that the sixth side 73 is a straight line. In practice, the first chamfer α is formed by an etching process, and the sixth side 73 in the first chamfer α may be an approximately straight line or arc.

As shown in FIG. 15, at least one of the connection lines 65 in the display panel includes a first subsection 651, a second subsection 652, and a third subsection 653, the first subsection 651 extends along the first direction y, the second subsection 652 extends along the second direction x, the third subsection 653 is connected between the first subsection 651 and the second subsection 652, the second direction x and the first direction y intersect with each other, and an extension direction of the third subsection 653 intersects with the first direction y and the second direction x. In this implementation, a corner of the at least one of the connection lines 65 is formed as a chamfered shape, that is, a tip is prevented from being formed at the position of the corner. As such, electrostatic concentration caused by a tip portion on the connection line 65 can be prevented, the electrostatic protection performance of the connection line 65 can be improved, and the electrical performance reliability of the connection line 65 for transmitting a signal is ensured.

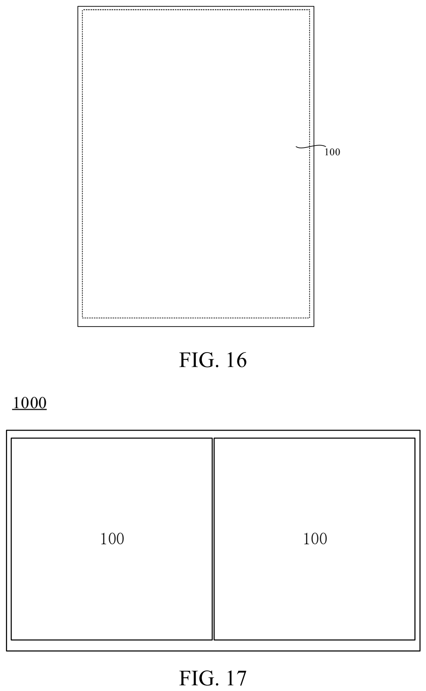

Based on the same inventive concept, an embodiment of the present disclosure further provides a display apparatus. FIG. 16 is a schematic diagram of the display apparatus provided by the embodiment of the present disclosure. As shown in FIG. 16, the display apparatus includes a display panel 100 provided by any one of the embodiments of the present disclosure. The structure of the display panel has been described in the above embodiments, and will not be repeated here. The display apparatus provided by the embodiment of the present disclosure may be, for example, an electronic device with a display function, such as a mobile phone, a tablet, a computer, a television, or a smart wearable product and the like. The display apparatus provided by the embodiment of the present disclosure may also be a transparent display apparatus, such as a transparent display window; or a spliced display apparatus, such as a large-screen for a conference room, an exhibition hall and the like.

In some implementations, FIG. 17 is a schematic diagram of another display apparatus provided by an embodiment of the present disclosure. As shown in FIG. 17, a spliced display apparatus 1000 is illustrated, and the display apparatus 1000 includes two display panels 100 spliced with each other. The display panel 100 is one provided by any one of the embodiments of the present disclosure. The spliced display apparatus provided by the embodiment of the present disclosure includes a total of a*b display panels arranged in a rows and b columns, a and b are both positive integers, and a and b are not both 1.

The above-mentioned are only the preferred embodiments of the present disclosure, and are not intended to limit the present disclosure. Any modifications, equivalent replacements, improvements, etc. made within the gist and principle of the present disclosure shall be included in the protection scope of the present disclosure.

Finally, it should be noted that the above embodiments are only used to illustrate the technical solutions of the present disclosure, not to limit them. Although the present disclosure has been described in detail with reference to the above-mentioned embodiments, those of skill in the art should understand that they can still modify the technical solutions recited in the above-mentioned embodiments, or replace some or all of the technical features with equivalent ones. However, these modifications or replacements do not make the essence of the corresponding technical solutions deviate from the scope of the technical solutions of the embodiments of the present disclosure.

## Claims

1. A display panel (100), comprising a substrate (00) and a first metal layer (M1) located on one side of the substrate (00), wherein the first metal layer (M1) comprises a first metal portion (M11) and a second metal portion (M12) which are connected to each other; and
the first metal portion (M11) comprises a plurality of first exhaust holes (10), and the second metal portion (M12) comprises a plurality of second exhaust holes (20), wherein an arrangement mode of the plurality of first exhaust holes (10) is different from an arrangement mode of the plurality of second exhaust holes (20).

2. The display panel (100) according to claim 1, wherein,
the second metal portion (M12) at least partially surrounds the first metal portion (M11).

3. The display panel (100) according to claim 1, further comprising a pixel region (Z1) and a non-pixel region (Z2), wherein at least a part of the first metal portion (M11) is located in the pixel region (Z1), the pixel region (Z1) comprises light-emitting elements (60), and the second metal portion (M12) is located in the non-pixel region (Z2).

4. The display panel (100) according to claim 1, wherein,
multiple first exhaust holes (10) of the plurality of first exhaust holes (10) are arranged along a first direction, multiple first exhaust holes (10) of the plurality of first exhaust holes (10) are arranged along a second direction, and the first direction and the second direction intersect with each other;
multiple second exhaust holes (20) of the plurality of second exhaust holes (20) are arranged along the first direction, and multiple second exhaust holes (20) of the plurality of second exhaust holes (20) are arranged along the second direction; and
in the first direction, a pitch between two adjacent first exhaust holes (10) is different from a pitch between two adjacent second exhaust holes (20); and/or in the second direction, a pitch between two adjacent first exhaust holes (10) is different from a pitch between two adjacent second exhaust holes (20).

5. The display panel (100) according to claim 4, wherein,
in the first direction, a width of the first exhaust hole (10) is equal to a width of the second exhaust hole (20), and a spacing between two adjacent first exhaust holes (10) is different from a spacing between two adjacent second exhaust holes (20); and/or
in the second direction, a width of the first exhaust hole (10) is equal to a width of the second exhaust hole (20), and a spacing between two adjacent first exhaust holes (10) is different from a spacing between two adjacent second exhaust holes (20).

6. The display panel (100) according to claim 1, wherein,
multiple first exhaust holes (10) of the plurality of first exhaust holes (10) are arranged along a first direction, and multiple first exhaust holes (10) of the plurality of first exhaust holes (10) are arranged along a second direction, wherein the first direction and the second direction intersect with each other; and multiple second exhaust holes (20) of the plurality of second exhaust holes (20) are arranged along the first direction, and multiple second exhaust holes (20) of the plurality of second exhaust holes (20) are arranged along the second direction; and
a pitch between the first exhaust holes (10) in the first direction is not equal to a pitch between the first exhaust holes (10) in the second direction, and/or a pitch between the second exhaust holes (20) in the first direction is equal to a pitch between the second exhaust holes (20) in the second direction.

7. The display panel (100) according to claim 1, wherein,
multiple first exhaust holes (10) of the plurality of first exhaust holes (10) are arranged into a first hole column (10L) along a first direction, multiple first exhaust holes (10) of the plurality of first exhaust holes (10) are arranged into a first hole row (10H) along a second direction, two adjacent first exhaust holes (10) in the first hole row (10H) belong to two adjacent first hole columns (10L), and the first direction and the second direction intersect with each other; and
multiple second exhaust holes (20) of the plurality of second exhaust holes (20) are arranged into a second hole column (20L) along the first direction, and multiple second exhaust holes (20) of the plurality of second exhaust holes (20) are arranged into a second hole row (20H) along the second direction; two adjacent second exhaust holes (20) in at least one second hole row (20H) are spaced by at least one second hole column (20L), and/or two adjacent second exhaust holes (20) in at least one second hole column (20L) are spaced by at least one second hole row (20H).

8. The display panel (100) according to claim 1, wherein,
multiple first exhaust holes (10) of the plurality of first exhaust holes (10) are arranged into a first hole column (10L) along a first direction, and three adjacent first exhaust holes (10) belonging to two adjacent first hole columns (10L) form a first triangle (41); a longest side of the first triangle (41) is a first side (411), an extension direction of the first side (411) intersects the first direction and a second direction, and the first direction and the second direction intersect with each other; and
multiple second exhaust holes (20) of the plurality of second exhaust holes (20) are arranged into a second hole column (20L) along the first direction, three adjacent second exhaust holes (20) belonging to two adjacent second hole columns (20L) form a second triangle (42), a longest side of the second triangle (42) is a second side (421), and the second side (421) extends along the first direction; and/or multiple second exhaust holes (20) of the plurality of second exhaust holes (20) are arranged into a second hole row (20H) along the second direction, three adjacent second exhaust holes (20) belonging to two adjacent second hole rows (20H) form a third triangle (43), a longest side of the third triangle (43) is a third side (431), and the third side (431) extends along the second direction.

9. The display panel (100) according to claim 1, wherein,
an arrangement density of the first exhaust holes (10) is less than an arrangement density of the second exhaust holes (20).

10. The display panel (100) according to claim 1, further comprising a second metal layer (M2) located on one side of the substrate (00), and the second metal layer (M2) and the first metal layer (M1) are located in different layers;
the second metal layer (M2) comprises a third metal portion (M21), and the third metal portion (M21) comprises a plurality of third exhaust holes (30); along a direction perpendicular to a plane of the substrate (00), the third metal portion (M21) and the first metal portion (M11) overlap, and the third exhaust holes (30) and the first exhaust holes (10) at least partially do not overlap; and/or
the second metal layer (M2) comprises a fourth metal portion (M22), and the fourth metal portion (M22) comprises a plurality of fourth exhaust holes; and along the direction perpendicular to the plane of the substrate (00), the fourth metal portion (M22) and the second metal portion (M12) overlap, and the fourth exhaust holes and the second exhaust holes (20) at least partially do not overlap.

11. The display panel (100) according to claim 10, wherein,
multiple of the plurality of fourth exhaust holes are arranged into a third hole column (40L) along a first direction, multiple of the plurality of fourth exhaust holes are arranged into a third hole row (40H) along a second direction, and the first direction and the second direction intersect with each other;
two adjacent fourth exhaust holes in at least one third hole row (40H) are spaced by at least one third hole column (40L), and two adjacent fourth exhaust holes in at least one third hole column (40L) are spaced by at least one third hole row (40H); and
an orthographic projection of at least one of the fourth exhaust holes on the substrate (00) is located in a region surrounded by orthographic projections of four adjacent second exhaust holes (20) on the substrate (00).

12. The display panel (100) according to claim 1, further comprising a second metal layer (M2) located on one side of the substrate (00), and the second metal layer (M2) and the first metal layer (M1) are located in different layers; the second metal layer (M2) comprises a third metal portion (M21), and along a direction perpendicular to a plane of the substrate (00), the third metal portion (M21) and the first metal portion (M11) overlap; and the third metal portion (M21) comprises third exhaust holes (30); and
the third metal portion (M21) comprises first electrodes (51) and second electrodes (52), the third metal portion (M21) has first grooves (53), the first electrodes (51) are located in the first grooves (53), and the second electrode (52) and at least one first groove (53) share at least one side wall.

13. The display panel (100) according to claim 12, further comprising light-emitting elements (60);
along the direction perpendicular to the plane of the substrate (00), one end of the light-emitting element (60) overlaps one of the first electrodes (51) and the other end of the light-emitting element (60) overlaps one of the second electrodes (52), and the light-emitting elements (60) and the third exhaust holes (30) do not overlap.

14. The display panel (100) according to claim 12, wherein,
a first gap (54) is formed between the first electrode (51) and a side wall of one of the first grooves (53) accommodating the at least one first electrode (51),
along the direction perpendicular to the plane of the substrate (00), the first exhaust holes (10) do not overlap the first gap (54).

15. The display panel (100) according to claim 12, wherein,
in a first direction, a spacing between two adjacent first exhaust holes (10) is d1, and a width of the third exhaust hole (30) is d2, wherein d1 > d2.

16. The display panel (100) according to claim 12, wherein,
the first electrodes (51) and at least one of the second electrodes (52) each comprise the third exhaust holes (30); and
a width of the second electrode (52) between two adjacent first grooves (53) in a second direction is greater than a width of the first exhaust hole (10) in the second direction, and/or a width of the first electrode (51) in the second direction is greater than a width of the first exhaust hole (10) in the second direction.

17. The display panel (100) according to claim 12, wherein,
the second metal layer (M2) comprises a fourth metal portion (M22) connected to the third metal portion (M21) and at least partially surrounding the third metal portion (M21); and
along the direction perpendicular to the plane of the substrate (00), the fourth metal portion (M22) and the second metal portion (M12) overlap; and the fourth metal portion (M22) comprises a plurality of fourth exhaust holes.

18. The display panel (100) according to claim 17, wherein,
an area of at least one of the third exhaust holes (30) is smaller than an area of the fourth exhaust hole.

19. The display panel (100) according to claim 1, further comprising a second metal layer (M2) located on one side of the substrate (00), and the second metal layer (M2) and the first metal layer (M1) are located in different layers; the second metal layer (M2) comprises a fourth metal portion (M22), and along a direction perpendicular to a plane of the substrate (00), the fourth metal portion (M22) and the second metal portion (M12) overlap; and the fourth metal portion (M22) comprises a plurality of fourth exhaust holes;
multiple of the plurality of fourth exhaust holes are arranged into a third hole column (40L) along a first direction, multiple of the plurality of fourth exhaust holes are arranged into a third hole row (40H) along a second direction, and the first direction and the second direction intersect with each other;
two adjacent fourth exhaust holes in the third hole row (40H) are spaced by at least one third hole column (40L), and two adjacent fourth exhaust holes in the third hole column (40L) are spaced by at least one third hole row (40H); and
an orthographic projection of at least one of the fourth exhaust holes on the substrate (00) is located in a region surrounded by orthographic projections of four adjacent second exhaust holes (20) on the substrate (00).

20. The display panel (100) according to claim 1, further comprising connection lines (65), pixel circuits (64), and light-emitting elements (60) located on one side of the substrate (00), wherein one end of the connection line (65) is connected to one of the pixel circuits (64), and the other end of the connection line (65) is connected to one of the light-emitting elements (60); the connection lines (65) and the first metal layer (M1) are located in a same layer; and
the first metal layer (M1) comprises a second groove (55), and the connection lines (65) are located in the second groove (55).

21. The display panel (100) according to claim 20, wherein,
the light-emitting elements (60) comprise first light-emitting elements (60-1), and the pixel circuits (64) comprise first pixel circuits (641); an orthographic projection of the first light-emitting element (60-1) on the substrate (00) and an orthographic projection of the first pixel circuit (641) on the substrate (00) are staggered in a first direction and/or a second direction; and the first pixel circuit (641) is connected to the first light-emitting elements (60-1) through the connection lines (65).

22. The display panel (100) according to claim 20, further comprising a second metal layer (M2) located on one side of the substrate (00), wherein the second metal layer (M2) and the first metal layer (M1) are located in different layers, the second metal layer (M2) comprises a third metal portion (M21), and along a direction perpendicular to a plane of the substrate (00), the third metal portion (M21) and the first metal portion (M11) overlap;
the third metal portion (M21) comprises first electrodes (51) and first grooves (53), and the first electrodes (51) are located in the first grooves (53); and
one end of the connection line (65) is connected to one of the first electrodes (51) through a via hole.

23. The display panel (100) according to claim 20, wherein,
the first exhaust holes (10) comprise a first exhaust sub-hole adjacent to the second groove (55), and the first exhaust sub-hole is not in communication with the second groove (55); and/or
the second exhaust holes (20) comprise a second exhaust sub-hole adjacent to the second groove (55), and the second exhaust sub-hole is not in communication with the second groove (55).

24. The display panel (100) according to claim 23, wherein,
the first exhaust holes (10) comprise a third exhaust sub-hole, and an area of the third exhaust sub-hole is greater than an area of the first exhaust sub-hole; and/or the second exhaust holes (20) comprise a fourth exhaust sub-hole, and an area of the fourth exhaust sub-hole is greater than an area of the second exhaust sub-hole.

25. The display panel (100) according to claim 23, wherein,
a distance between the first exhaust sub-hole and the second groove (55) is d3, wherein d3 ≥ 3 µm; and/or a distance between the second exhaust sub-hole and the second groove (55) is d4, wherein d4 ≥ 3 µm.

26. The display panel (100) according to claim 23, wherein,
at least one second groove (55) comprises a first inner wall (551) extending along a first direction and a second inner wall (552) extending along a second direction, the first inner wall (551) and the second inner wall (552) are in communication with each other to form a first corner, and the second direction and the first direction intersect with each other; and
at least one first exhaust sub-hole is formed as an L-shaped first exhaust sub-hole around the first corner; and/or at least one second exhaust sub-hole is formed as an L-shaped second exhaust sub-hole around the first corner.

27. The display panel (100) according to claim 20, wherein,
the first metal layer (M1) comprises at least one first chamfer, the first chamfer comprises a fourth side (71), a fifth side (72), and a sixth side (73), the sixth side (73) is connected between the fourth side (71) and the fifth side (72), the fourth side (71) extends along a first direction, the fifth side (72) extends along a second direction, and the second direction and the first direction intersect with each other; and
the fourth side (71), the fifth side (72), and the sixth side (73) form a corner of the second groove (55).

28. The display panel (100) according to claim 20, wherein,
at least one of the connection lines (65) comprises a first subsection (651), a second subsection (652), and a third subsection (653), the first subsection (651) extends along a first direction, the second subsection (652) extends along a second direction, the third subsection (653) is connected between the first subsection (651) and the second subsection (652), and the second direction and the first direction intersect with each other; and an extension direction of the third subsection (653) intersects with the first direction and the second direction.

29. A display apparatus (1000), comprising the display panel (100) according to any one of claims 1 to 28.
